# EUROPEAN PATENT SPECIFICATION

(11) **EP 0 399 531 B1**
(45) Date of publication and mention of the grant of the patent: **29.12.1997**
(21) Application number: 90109899.6
(22) Date of filing: 23.05.1990
(51) Int. Cl.: H01L 27/108, G11C 11/409

(54) **Semiconductor memory device**
Halbleiterspeicherbauteil
Dispositif semi-conducteur à mémoire

(30) Priority: 23.05.1989 JP 129916/89
(43) Date of publication of application: 28.11.1990
(73) Proprietor: KABUSHIKI KAISHA TOSHIBA, Kawasaki-shi, Kanagawa-ken 210 (JP)
(72) Inventor: Kumagai, Jumpei, c/o Intellectual Property Div., Minato-ku, Tokyo 105 (JP); Sawada, Shizuo c7o Intellectual Property Div., Minato-ku Tokyo 105 (JP)
(74) Representative: Lehn, Werner, Dipl.-Ing.

(56) References cited:
- EP-A- 0 055 572
- EP-A- 0 055 572
- US-A- 4 700 328
- IEDM 88 TECHNICAL DIGEST, 1989, pages 596-599, New York, US; S. KIMURA et al.: "A new stacked capacitor DRAM cell"
- PATENT ABSTRACTS OF JAPAN, vol. 11, no. 130 (E-502)[2577], 23rd April 1987; & JP-A-61 274 357
- PATENT ABSTRACTS OF JAPAN, vol. 13, no. 106 (E-726)[3454], 14th March 1989; & JP-A-63 278 363 (HITACHI) 16-11-1988
- PATENT ABSTRACTS OF JAPAN, vol. 13, no. 301 (E-785)[3649], 11th June 1989; & JP-A-01 80 068 (HITACHI LTD) 24-03-1989

## Description

This invention relates to a semiconductor memory device, and more particularly to a cell array pattern in one-transistor·one-capacitor type dynamic memory cells.

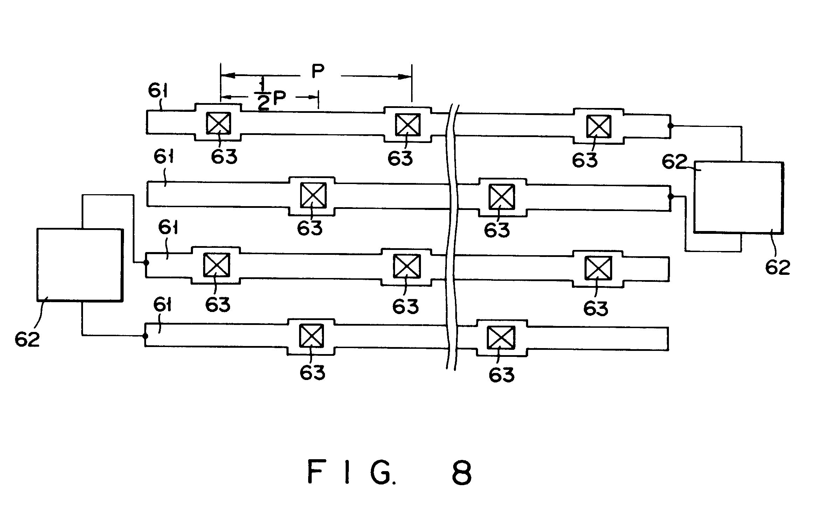

As an arrangement of a dynamic memory cell with a one-transistor·one-capacitor structure in a dynamic memory, various patterns have been proposed to increase the integration density thereof. Fig. 8 schematically shows an example of a conventional cell array pattern of folded bit line type. A similar DRAM array is described in International Electron Devices Meeting, Technical Digest, IEDM-88, IEEE, San Francisco, CA, Dec. 11-14, 1988 pp. 596-9. In Fig. 8, 61 denotes bit lines arranged in parallel with one another, and 62 denotes bit line sense amplifiers arranged on both sides of the bit lines 61. Adjacent two of the bit lines 61 make one complementary pair and are connected to a corresponding one of the bit line sense amplifiers 62. Each of the bit lines 61 has contacts or connection members 63 which are in contact with drain regions (or source regions) of memory cell transistors (charge transfer transistors) at desired pitch P in a longitudinal direction thereof. In this case, if desired two bit lines adjacent to each other are noted, a position of a transistor contact 63 in one bit line 61 is deviated by 1/2 pitch in the bit line direction from a position of a transistor contact 63 of an adjacent bit line 61.

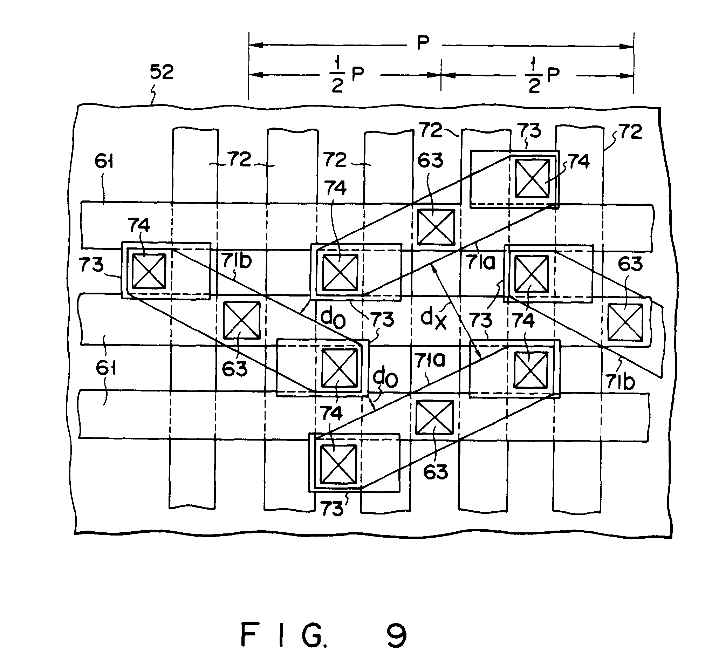

Fig. 9 shows part of the cell array pattern of Fig. 8 in detail. In Fig. 9, 61 denotes bit lines, 63 bit line contacts, 71a cell regions having a pattern extending diagonally right and upward, and 71b cell regions having a pattern extending diagonally right and downward, respectively. The two kinds of cell region patterns are alternately arranged every 1/2 pitch in the bit line direction. Further, 72 denotes word lines which are also used as gate electrodes of the cell transistors, 73 capacitor storage electrodes provided every memory cells, and 74 contacts (capacitor contacts) for connecting source regions 43 or 44 of cell transistors to the capacitor storage electrodes 73, respectively.

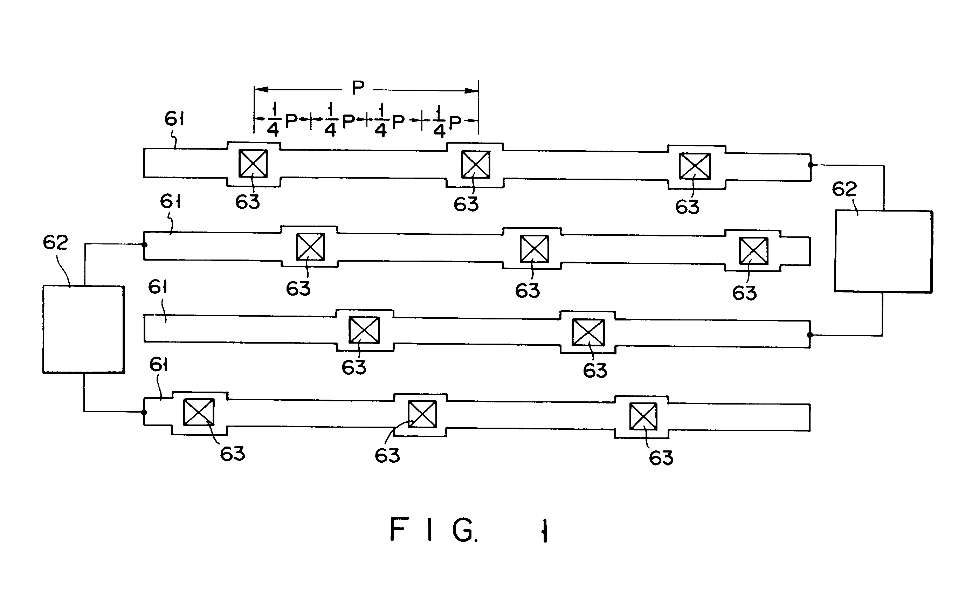

The cell regions 71a and 71b have a cross-sectional structure as shown in Fig. 4. In Fig. 4, 41 denotes a semiconductor substrate, 42 denotes a field insulating film for cell isolation selectively formed in the semiconductor substrate 41, 43 and 44 denote source regions of first and second cell transistors which are formed of diffused regions of a conductivity type opposite to that of the semiconductor substrate, 45 denotes a common drain region of the first and second cell transistors which is formed of a diffused region of a conductivity type opposite to that of the semiconductor substrate, and 46 and 47 denote the gate electrodes of the first and second cell transistors which are provided through a thin insulating film 48 above the semiconductor substrate 41 and used as part of the word lines 72. Further, 49 denotes a first interlevel insulator, 61 denotes the bit lines, 63 denotes the transistor contact which is in contact with the drain region 45 through a contact hole. 72 denotes the word lines and 50 denotes a second interlevel insulator.

The first and second cell transistors include a charge storage capacitor, respectively. That is, capacitor storage electrodes denoted by 73 are partly disposed on the second interlevel insulator 50 so as to be located above part of the upper portion of the bit lines 61, and are in contact with the source regions 43 and 44 of the cell transistors via contact holes, respectively. A capacitor plate electrode 52 is provided so that the capacitor storage electrodes 73 are faced through a thin capacitor insulating film 51, thereby providing a stacked capacitor.

In the above cell array pattern, the bit lines 61 and the word lines 72 are arranged in respective directions to intersect with each other, the cell region 71a or 71b for two cell transistors is provided to traverse one of the bit lines 61 and adjacent two of the word lines 72, respectively, each bit line 61 is in contact with the common region of the two cell transistors at the portion intersecting the bit line 61 and the cell region 71a or 71b, the capacitors are connected to the two cell transistors, and the cell regions 71a and 71b are provided with patterns which are inclined in the right-upward and right-downward directions, respectively, and are alternately arranged every 1/2 pitch in the bit line direction.

However, when the cell regions 71a and 71b are provided in this way, it is difficult to increase the integration density of the cell regions. That is, as shown in Fig. 9, the integration density of the cell regions is determined by the minimum distance d0 between the adjacent two patterns having different directions. However, the minimum distance dx between the adjacent two patterns having the same directions has a sufficient space as compared with the minimum distance d0, thereby bringing a uselessly occupied area.

As described above, since the conventional dynamic memory cells are provided by alternately arranging two kinds of patterns every 1/2 pitch as the cell regions, it is difficult to increase the integration density of cell regions.

A DRAM array in which cell regions are arranged parallel to the bit lines and shifted ¼ pitch in the bit line direction is known from EP-A-0 055 572.

Accordingly, an object of this invention is to provide a semiconductor memory device in which the pattern density of cell regions in cell array patterns of dynamic memory cell arrays is increased.

In a semiconductor memory device having one-transistor·one-capacitor type dynamic memory cells according to the invention, cell regions for cell transistor pairs are provided in a semiconductor substrate so as to traverse one bit line and two adjacent word lines, respectively, and the patterns of the cell regions have the same direction. Contacts are provided for electrically connecting respective bit lines and common regions of cell transistor pairs to one another at portions where the cell regions intersect with the bit lines every desired pitch in the bit line direction. In this case, a distance between adjacent two contacts of a desired bit line is given as one pitch, and the contacts of the adjacent bit lines are shifted in the bit line direction by approximately 1/2ⁿ pitch (n is a natural number greater than or equal to 2).

The novel and distinctive features of the invention are set forth in the claims appended to the present application. The invention itself, however, together with further objects and advantages thereof may best be understood by reference to the following description and accompanying drawings in which:
Fig. 1 is a plan view showing part of a cell array pattern of a semiconductor memory device according to one embodiment of the present invention;
Fig. 2 is a plan view showing the part of the cell array pattern of Fig. 1 in detail;
Fig. 3 is a plan view showing a pattern of source, channel and drain regions of a cell transistor pair in a cell region in Fig. 2;
Fig. 4 is a cross-sectional view of the memory cell region of Fig. 2;
Fig. 5 is a plan view showing a modified example of word and bit line patterns near contacts of Fig. 2;
Fig. 6 is a plan view showing part of a cell array pattern of a semiconductor memory device according to another embodiment of the present invention;
Fig. 7 is a plan view showing the part of the cell array pattern of Fig. 6;
Fig. 8 is a plan view showing part of the cell array pattern in the conventional dynamic memory; and
Fig. 9 is a plan view showing the part of the cell array pattern of Fig. 8.

There will now be described one embodiment of the invention with reference to the accompanying drawings.

A cell array pattern of dynamic memory cells shown in Figs. 1 and 2 is similar to that of the conventional dynamic memory cells explained with reference to Figs. 8 and 9 except that respective transistor contacts 63 of adjacent bit lines 61 are shifted by approximately 1/2ⁿ (for example, 1/4) pitch in the bit line direction, and that the patterns of cell regions 11 have the same direction (that is, the patterns of cell regions 11 are of one kind).

Fig. 1 shows part of the cell array pattern of folded bit line type as an example of a cell array pattern of dynamic memory cells with a one-transistor·one-capacitor structure in a dynamic memory. That is, in Fig. 1, 61 denotes bit lines arranged in parallel with one another, 62 denotes bit line sense amplifiers arranged at both ends of the bit lines 61. A sense amplifier 62 is successively connected to a complementary pair arrangement which includes adjacent bit lines 61 between which another bit line 61 is disposed. Each of the bit lines 61 has contacts 63, which are in contact with drain regions (or source regions) of cell transistors, at a regular interval of constant pitch P in its bit line direction. In this case, a distance between adjacent two contacts of the bit line is given as one pitch. The contacts 63 of the bit lines 61 are successively deviated from contacts 63 of an adjacent bit lines 61 by 1/4 pitch in the bit line direction.

Fig. 2 shows part of the cell array pattern of Fig. 1 in detail. The bit lines 61 and word lines 72 are arranged in directions to intersect with each other, and each cell region 11 for two cell transistors is provided so as to traverse one desired bit line 61 and adjacent two word lines 72, respectively. In this case, the respective patterns of the cell regions 11 have the same direction, and one kind of the cell region patterns are repeatedly arranged as a whole. Further, each of the bit lines 61 is in contact with a common region of two cell transistors every desired pitch in its longitudinal direction at portions intersecting with cell regions 11. The two cell transistors are provided so as to include two capacitors, thereby providing two dynamic memory cells with one-transistor·one-capacitor structure per one cell region.

In a plurality of bit lines 61 arranged in parallel with one another, the transistor contacts 63 of one of the bit lines 61 are successively deviated by approximately 1/4 pitch in the bit line direction from the corresponding transistor contacts 63 of another bit lines 61 which are adjacent to the above bit line 61. Further, a capacitor storage electrode 73 is provided every each memory cell and is in contact with a corresponding cell transistor. In Fig. 2, 74 denotes contacts between the source regions 43 or 44 of the cell transistors and the capacitor storage electrodes 73.

Fig. 3 shows a pattern of the source regions 43 and 44, channel regions 12 and drain region 45 of the cell transistor pair in the cell region 11 shown in Fig. 2.

Fig. 4 shows the cross section of the memory cell region of Fig. 2. In the drawing, 41 denotes a semiconductor substrate, 42 denotes a field insulating film for cell isolation selectively formed in the substrate, 43 and 44 denote the source regions of first and second cell transistors which are formed of diffused regions of a conductivity type opposite to that of the substrate, 45 denotes the common drain region of the first and second cell transistors which is formed of a diffused region of a conductivity type opposite to that of the substrate, and 46 and 47 denote the gate electrodes of the first and second cell transistors which are disposed on a thin gate insulating film 48 provided on the substrate 41 and which are part of the word lines 72, respectively. Further, 49 denotes a first interlevel insulator, 61 denotes the bit lines, and 63 denotes the transistor contact which is in contact with the drain region 45 through a contact hole, respectively. 72 denotes the word lines and 50 denotes a second interlevel insulator.

The first and second cell transistors include a charge storage capacitor, respectively. That is, capacitor storage electrodes denoted by 73 are partly disposed on the second interlevel insulator 50 so as to be located above part of the upper portion of the bit lines 61, and are in contact with the source regions 43 and 44 of the cell transistors through contact holes, respectively. A capacitor plate electrode 52 is provided so that the capacitor storage electrode 73 are faced through a thin capacitor insulating film 51, thereby providing a stacked capacitor.

According to the cell array pattern described above, the cell regions 11 are provided by one kind of repeated patterns having the same directions. In this case, the integration density of the cell regions 11 is determined by the minimum distance d1 between the adjacent patterns in the word line direction or by the minimum distance d2 between the adjacent patterns in the bit line direction, and since a distance between adjacent patterns, which are deviated from each other by approximately 1/4 pitch in the bit line direction, is reduced to of the order of the minimum distance d1 or d2, the density of the cell regions 11 can be increased, thereby further increasing the integration density thereof.

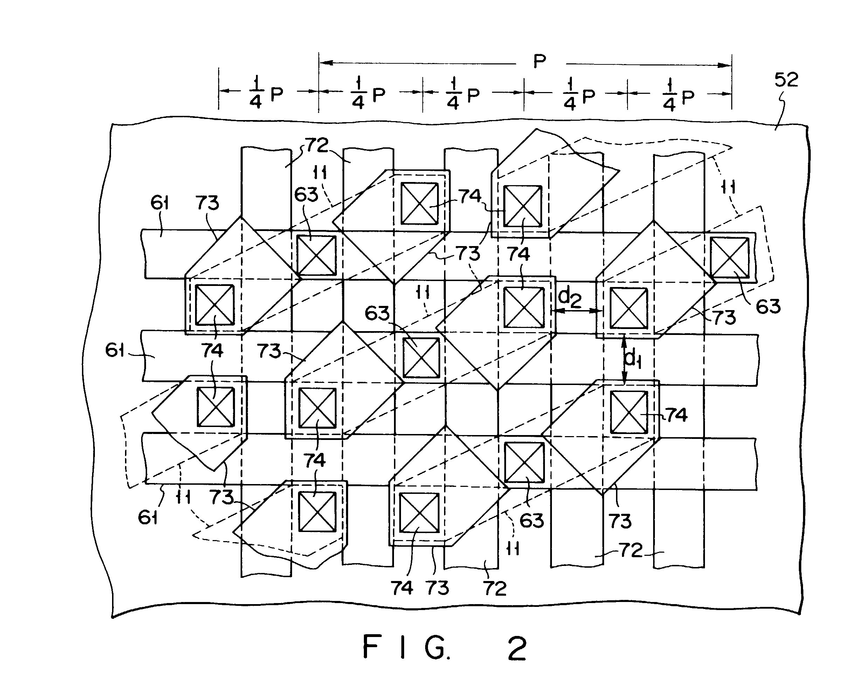

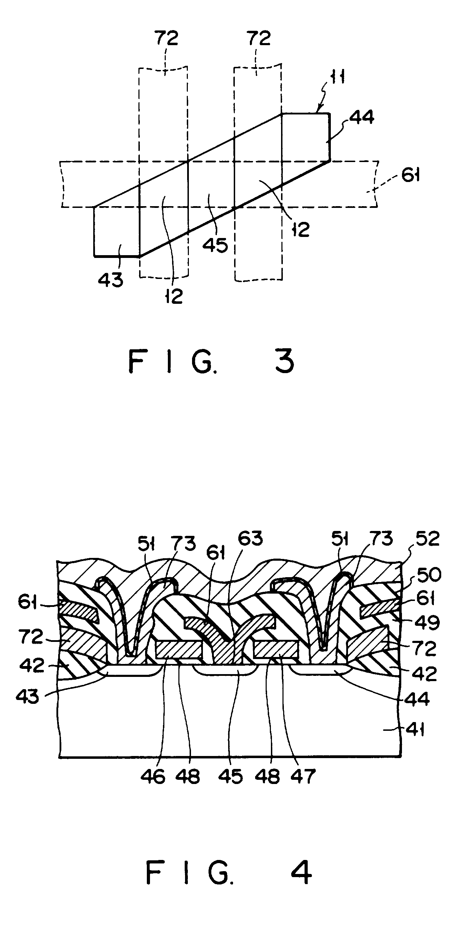

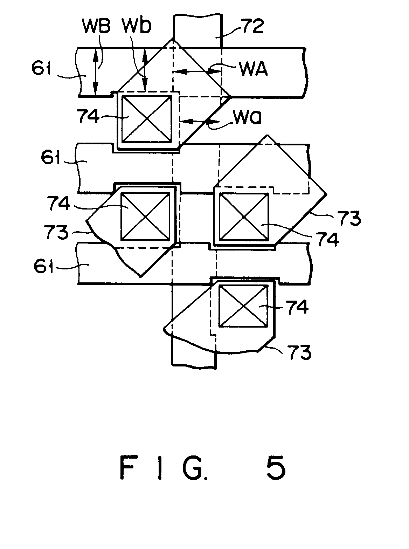

In order to obtain the sufficient area of each contact in the above embodiment, particularly, the sufficient area of each contact 74 between the source region 43 or 44 of the cell transistor and the capacitor storage electrode 73, the word line width Wa near the contact 74 may be made narrower than the word line width WA of the other portion thereof as shown in Fig. 5. Likewise, the bit line width Wb near each contact 74 may be made narrower than the bit line width WB of the other portion thereof.

Further, in the above embodiment, part of the capacitor storage electrode 73 is provided above part of the bit line 61, but it may be located below part of the bit line 61.

Next, another embodiment of the invention will be described.

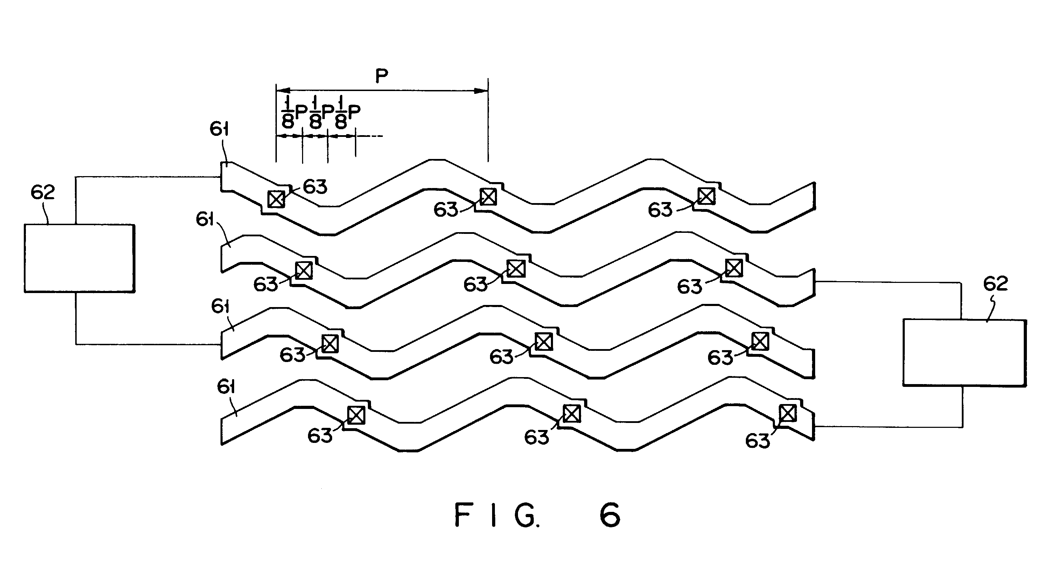

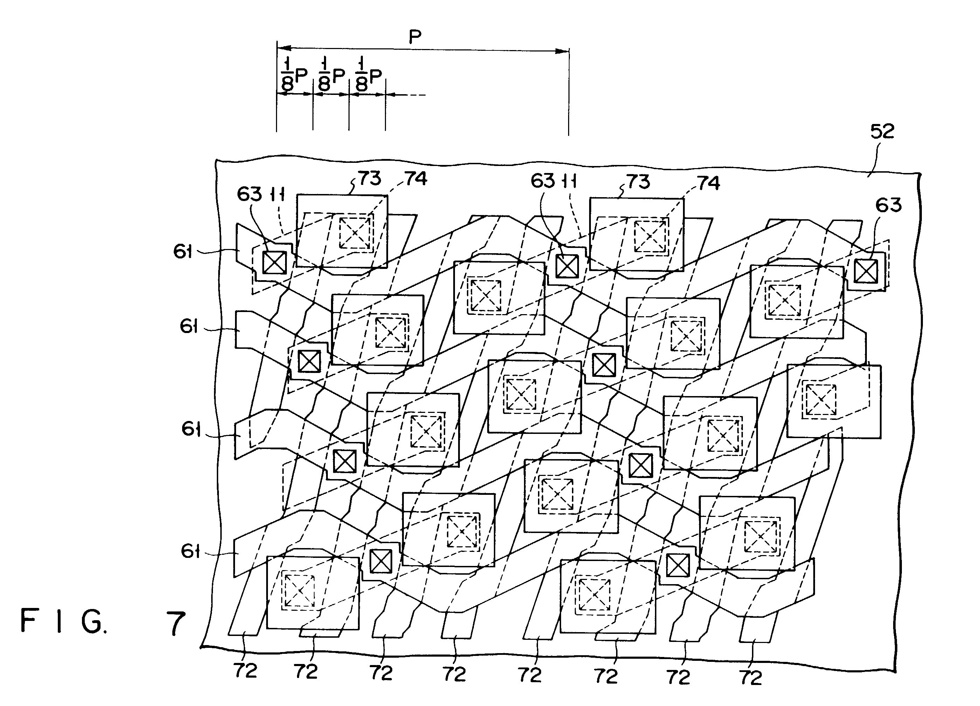

Figs. 6 and 7 show a cell array pattern of folded bit line type dynamic memory cells in which contacts of the adjacent bit lines are deviated from one another by 1/8 pitch, and the same parts or components as those of Fig. 2 are denoted by the same reference numerals.

As shown in Fig. 6, a sense amplifier 62 is successively connected to both ends of bit lines which provide a complementary pair arrangement which includes adjacent bit lines 61 between which another bit line 61 is disposed. Each of the bit lines 61 has contacts 63, which are in contact with drain regions (or source regions) of cell transistors, at a regular interval of constant pitch P in its bit line direction. In this case, the contacts 63 of the bit lines 61 are successively deviated from contacts 63 of adjacent bit lines 61 by 1/8 pitch in the bit line direction.

Fig. 7 shows part of the cell array pattern of Fig. 6 in detail.

Likewise the first embodiment shown in Fig. 2, in Fig. 7, the word lines 72 are insulatively disposed above the cell regions 11 formed in the semiconductor substrate, and the bit lines 61 are insulatively formed over the word lines. Also, the cell regions 11 are formed of one kind of repeated patterns having the same direction. Each of the bit lines 61 are electrically connected to common regions of transistor pairs in cell regions 11 via the contacts 63, respectively. In this embodiment, the contacts 63 of adjacent bit lines 61 are deviated by 1/8 pitch in the bit line direction from one another. An insulating film (not shown) is formed to cover the bit lines, and the capacitor storage electrodes 73 are provided on the insulating film. The storage electrodes 73 are connected to the source regions of corresponding cell transistors via the contacts 74. Further, capacitor plate electrodes 52 are disposed to face the storage electrodes 73 via an insulating film.

As described above, in this embodiment, the basic structure is the same as that of the first embodiment except that the contacts 63 of the adjacent bit lines 61 are deviated from one another by 1/8 pitch in the bit line direction, and the pattern density of the cell regions can be further increased.

Further, this invention is not limited to the dynamic memory devices having the folded bit line type cell array pattern as described in the above embodiments, but can be applicable to dynamic memory devices using open bit line type cell array patterns.

Reference signs in the claims are intended for better understanding and shall not limit the scope.

## Claims

1. A semiconductor memory device having an array of one-transistor/one-capacitor type dynamic memory cells comprising:
a plurality of bit lines (61) and word lines (72) insulatively disposed above a semiconductor substrate (41), said bit lines (61) being separated from said word lines (72) by a desired distance and intersecting with said word lines (72);
cell regions (11) formed in said semiconductor substrate (41), each of said cell regions (11) having the same pattern and including a pair of field effect transistors having a common drain region (45) connected to one of said bit lines (61), gate electrodes (46, 47) formed by two adjacent said word lines (72), and source regions (43, 44) each connected via a respective capacitor contact (74) to respective capacitors (73, 51, 52) insulatively disposed above said semiconductor substrate (41); and
drain contacts (63) electrically connecting said common drain regions (45) to said bit lines (61) in a bit line direction wherein said drain contacts (63) of said bit lines (61) adjacent to one another are successively shifted in said bit line direction by approximately ½ⁿ pitch where n is a natural number equal to or more than 2, when a distance between adjacent two drain contacts (63) of a desired bit line (61) is given as one pitch;
**characterized in that**
each of said cell regions (11) crosses a single said bit line (61) between said capacitor contacts (74) such that said cell regions (11) are all arranged at the same oblique angle and direction with respect to said bit lines (61).

2. The semiconductor memory device according to claim 1, characterized in that said bit lines (61) are arranged in a wave-like pattern.

3. The semiconductor memory device according to claim 1, characterized in that said bit lines (61) and word lines (72) are arranged in a wave-like pattern.

4. The semiconductor memory device according to claim 1, characterized in that each of said capacitors is a stacked capacitor which includes a capacitor storage electrode (73) connected via said respective capacitor contact (74) to said respective source regions (43, 44), a thin insulating film (51) for covering a surface of said capacitor storage electrode (73), and a capacitor plate electrode (52) provided on said insulating film (51).

5. The semiconductor memory device according to claim 1, characterized in that a line width of at least one of said bit lines (61) and word lines (72) is made narrower in a portion near contacts (74) for connecting said source regions (43, 44) to said respective capacitors than in the other portion thereof.

6. The semiconductor memory device according to claim 1, characterized in that a bit line sense amplifier (62) is connected to both ends of bit lines (61) so that two bit lines (61) provide a complementary pair arrangement between which another bit line (61) is disposed.

7. The semiconductor memory device according to claim 1, comprising
m said bit lines (61) arranged above said semiconductor substrate (41) and extending in a first direction; n said word lines (72) extending in a second direction, so as to intersect said bit lines (61); and
at least first, second and third memory cell pairs each being formed in each of said cell regions (11);
wherein said first memory cell pair has a first capacitor contact between an n and an n+1 word lines (71) and between an m and m+1 bit lines (61), a second capacitor contact between an n+2 and an n+3 word lines (72) and between the m+1 and an m+2 bit lines (61), and a drain contact at the m+1 bit line (61); wherein said second memory cell pair has a first capacitor contact between the n+2 and the n+3 word lines (72) and between the m+2 and an m+3 bit lines (61), a second capacitor contact between an n+4 and an n+5 word lines (72) and between m+3 and an m+4 bit lines (61), and a drain contact at the m+3 bit line (61); and wherein said third memory cell pair has a first capacitor contact between the n+3 and the n+4 word lines (72) and between the m+1 and the m+2 bit lines (61), a second capacitor contact between the n+5 and n+6 word lines and between the m+2 and the m+3 bit lines (61), and a drain contact at the m+2 bit line (61).

8. The semiconductor memory device according to claim 1, characterized in that capacitor storage electrodes (73) are partly disposed on second interlevel insulator (50) so as to be located above part of the bit lines (61) and the gate electrodes (46, 47).

## Patentansprüche

1. Eine Halbleiterspeichervorrichtung mit einer Anordnung von dyanamischen Speicherzellen eines Ein-Transistor/Ein-Kondensator-Typs, umfassend:
eine Vielzahl von Bitleitungen (61) und Wortleitungen (72), die isoliert über einem Halbleitersubstrat (41) angeordnet sind, wobei die Bitleitungen (61) von den Wortleitungen (72) durch einen erwünschten Abstand beabstandet sind und die Wortleitungen (72) schneiden;
Zellenbereiche (11), die in dem Halbleitersubstrat (41) ausgebildet sind, wobei jeder der Zellenbereiche (11) das gleiche Muster aufweist und ein Paar von Feldeffekttransistoren einschließt, die einen gemeinsamen Drainbereich (45) aufweisen, der mit einer der Bitleitungen (61) verbunden ist, Gate-Elektroden (46, 47), die durch zwei benachbarte Wortleitungen (72) gebildet werden, und Sourcebereiche (43, 44), wobei jeder über einen jeweiligen Kondensatorkontakt (74) mit jeweiligen isoliert über dem Halbleitersubstrat (41) angeordneten Kondensatoren (73, 51, 52) verbunden ist; und
Drainkontakte (63), die die gemeinsamen Drainbereiche (45) elektrisch mit den Bitleitungen (61) in einer Bitleitungsrichtung verbinden, wobei benachbarte Drainkontakte (63) der Bitleitungen (61) aufeinanderfolgend in der Bitleitungsrichtung um ungefähr 1/2ⁿ Zwischenraum verschoben sind, wobei n eine natürliche Zahl gleich oder größer als 2 ist, wobei ein Abstand zwischen zwei benachbarten Drainkontakten (63) eine erwünschten Bitleitung (61) als ein Zwischenraum gegeben ist;
dadurch **gekennzeichnet**, daß
jeder der Zellenbereiche (11) eine einzige der Bitleitungen (61) zwischen den Kondensatorkontakten (74) kreuzt, so daß die Zellenbereiche (11) alle im gleichen geneigten Winkel und Richtung mit Bezug auf die Bitleitungen (61) angeordnet sind.

2. Die Halbleiterspeichervorrichtung nach Anspruch 1, dadurch gekennzeichnet, daß die Bitleitungen (61) in einem Wellenformmuster angeordnet sind.

3. Die Halbleiterspeichervorrichtung nach Anspruch 1, dadurch gekennzeichnet, daß die Bitleitungen (61) und Wortleitungen (72) in einem wellenförmigen Muster angeordnet sind.

4. Die Halbleiterspeichervorrichtung nach Anspruch 1, dadurch gekennzeichnet, daß jeder der Kondensatoren ein geschichteter Kondensator ist, der eine Kondensatorspeicherelektrode (73) einschließt, die über den jeweiligen Kondensatorkontakt (74) mit jeweiligen Sourcebereichen (43, 44) verbunden ist, einen dünnen Isolierfilm (51), um eine Oberfläche der Kondensatorspeicherelektrode (73) zu bedecken und eine Kondensatorplattenelektrode (52), die auf dem Isolierfilm (51) bereitgestellt ist.

5. Die Halbleiterspeichervorrichtung nach Anspruch 1, dadurch gekennzeichnet, daß eine Leitungsbreite von zumindest einer der Bitleitungen (61) und Wortleitungen (72) in einem Bereich nahe von Kontakten (74), um die Sourcebereiche (43, 44) mit jeweiligen Kondensatoren zu verbinden, schmaler ausgebildet ist als in anderen Bereichen.

6. Die Halbleiterspeichervorrichtung nach Anspruch 1, dadurch gekennzeichnet, daß ein Bitleitungs-Abfühlverstärker (62) mit beiden Enden von Bitleitungen (61) verbunden ist, so daß zwei Bitleitungen (61) eine komplementäre Paaranordnung bereitstellen, zwischen der eine andere Bitleitung (61) angeordnet ist.

7. Die Halbleiterspeichervorrichtung nach Anspruch 1, umfassend:
m der Bitleitungen (61), die über dem Halbleitersubstrat (41) angeordnet sind und sich in einer ersten Richtung erstrecken; n der Wortleitungen (72), die sich in einer zweiten Richtung erstrecken, so daß sie die Bitleitungen (61) schneiden; und
zumindest ein erstes, zweites und drittes Speicherzellenpaar, wobei jedes in jedem der Zellenbereiche (11) ausgebildet ist;
wobei das erste Speicherzellenpaar einen ersten Kondensatorkontakt zwischen einer n und einer n+1 Wortleitung (71) und zwischen einer m und m+1 Bitleitung (61) aufweist, einen zweiten Kondensatorkontakt zwischen einer n+2 und einer n+3 Wortleitung (72) und zwischen der m+1 und einer m+2 Bitleitung (61), und einen Drainkontakt an der m+1 Bitleitung (61); wobei das zweite Speicherzellenpaar einen ersten Kondensatorkontakt zwischen der n+2 und der n+3 Wortleitung (72) und zwischen der m+2 und einer m+3 Bitleitung (61) aufweist, einen zweiten Kondensatorkontakt zwischen einer n+4 und einer n+5 Wortleitung (72) und zwischen der m+2 und einer m+4 Bitleitung (61), und einen Drainkontakt an der m+3 Bitleitung (61); und wobei das dritte Speicherzellenpaar einen ersten Kondensatorkontakt zwischen der m+3 und der m+4 Wortleitung (72) und zwischen der m+1 und der m+2 Bitleitung (61) aufweist, einen zweiten Kondensatorkontakt zwischen der n+5 und einer n+6 Wortleitung und zwischen der m+2 und der m+3 Bitleitung (61) und einen Drainkontakt an der m+2 Bitleitung (61).

8. Die Halbleiterspeichervorrichtung nach Anspruch 1, dadurch gekennzeichnet, daß die Kondensatorspeicherelektroden (73) teilweise auf zweiten Zwischenniveau-Isolatoren (50) angeordnet sind, so daß sie über einem Teil der Bitleitungen (61) und den Gate-Elektroden (46, 47) angeordnet sind.

## Revendications

1. Dispositif de mémoire à semi-conducteur ayant des cellules de mémoire dynamique du type à un transistor / un condensateur, comprenant :
plusieurs lignes de binaire (61) et lignes de mot (72) disposées, de façon à être isolées, au-dessus d'un substrat semi-conducteur (41), lesdites lignes de binaire (61) étant séparées desdites lignes de mot (72) par une distance voulue et se coupant avec lesdites lignes de mot (72) ;
des zones de cellule (11) formées dans ledit substrat semi-conducteur (41), chacune desdites zones de cellule (11) ayant le même motif et incluant une paire de transistors à effet de champ ayant une zone de drain (45) commune connectée à l'une desdites lignes de binaire (61), des électrodes de grille (46, 47) formées par deux desdites lignes de mot (72) adjacentes, et des zones de source (43, 44) chacune connectée, par l'intermédiaire d'un contact de condensateur (74) respectif à des condensateurs (73, 51, 52) respectifs disposés, de façon à être isolés, au-dessus dudit substrat semi-conducteur (41) ; et
des contacts de drain (63) reliant électriquement lesdites zones de drain (45) communes auxdites lignes de binaire (61) dans une direction de ligne de binaire, lesdits contacts de drain (63) desdites lignes de binaire (61) adjacents les uns aux autres étant décalés de manière successive dans ladite direction de ligne de binaire d'environ 1/2ⁿ de pas, où n est un nombre naturel égal ou supérieur à 2, lorsque la distance entre deux contacts de drain (63) adjacents d'une ligne de binaire (61) voulue constitue un pas;
caractérisé en ce que chacune desdites zones de cellule (11) coupe une seule desdites lignes de binaire (61) entre lesdits contacts de condensateur (74) de façon telle que lesdites zones de cellule (11) soient toutes disposées suivant le même angle oblique et la même direction par rapport auxdites lignes de binaire (61).

2. Dispositif de mémoire à semi-conducteur selon la revendication 1, caractérisé en ce que lesdites lignes de binaire (61) sont disposées en un motif de type ondulé.

3. Dispositif de mémoire à semi-conducteur selon la revendication 1, caractérisé en ce que lesdites lignes de binaire (61) et lesdites lignes de mot (72) sont disposées en un motif de type ondulé.

4. Dispositif de mémoire à semi-conducteur selon la revendication 1, caractérisé en ce que chacun desdits condensateurs est un condensateur à empilement qui comprend une électrode (73) d'accumulation de condensateur raccordée, par l'intermédiaire dudit contact de condensateur (74) respectif, auxdites zones de source (43, 44) respectives, un film isolant mince (51) destiné à recouvrir une surface de ladite électrode (73) d'accumulation de condensateur et une électrode (52) de plaque de condensateur disposée sur ledit film isolant (51).

5. Dispositif de mémoire à semi-conducteur selon la revendication 1, caractérisé en ce que la largeur de ligne d'au moins l'une desdites lignes de binaire (61) et desdites lignes de mot (72) est réalisée plus étroite dans une partie proche de contacts (74), destinés à raccorder lesdites zones de source (43, 44) audit condensateur respectif, que dans son autre partie.

6. Dispositif de mémoire à semi-conducteur selon la revendication 1, caractérisé en ce qu'un amplificateur de lecture (62) de ligne de binaire est connecté aux deux extrémités des lignes de binaire (61) de façon telle que deux lignes de binaire (61) constituent un agencement de paire complémentaire entre laquelle est disposée une autre ligne de binaire (61).

7. Dispositif de mémoire à semi-conducteur selon la revendication 1, comprenant :
m desdites lignes de binaire (61) disposées au-dessus dudit substrat semi-conducteur (41) et s'étendant dans une première direction ;
n desdites lignes de mot (72) s'étendant dans une seconde direction, de façon à couper lesdites lignes de binaire (61) ; et
au moins des première, deuxième et troisième paires de cellules de mémoire, chacune formée dans chacune desdites zones de cellules (11) ;
dans lequel ladite première paire de cellules de mémoire a un premier contact de condensateur entre une n et une n+1 lignes de mot (71) et entre une m et une m+1 lignes de binaire (61), un second contact de condensateur entre une n+2 et une n+3 lignes de mot (72) et entre la m+1 et une m+2 lignes de binaire (61), et un contact de drain au niveau de m+1 ligne de binaire (61) ; dans lequel ladite deuxième paire de cellules de mémoire à un premier contact de condensateur entre la n+2 et la n+3 lignes de mot (72) et entre la m+2 et une m+3 lignes de binaire (61), un second contact de condensateur entre une n+4 et une n+5 lignes de mot (72) et entre une m+3 et une m+4 lignes de binaire (61), et un contact de drain au niveau de la m+3 lignes de binaire (61) ; et dans lequel ladite troisième paire de cellules de mémoire a un premier contact de condensateur entre la n+3 et la n+4 lignes de mot (72) et entre la m+1 et la m+2 lignes de binaire (61), un second contact de condensateur entre la n+5 et la n+6 lignes de mot et entre la m+2 et la m+3 lignes de binaire (61), et un contact de drain au niveau de la m+2 ligne de binaire (61).

8. Dispositif de mémoire à semi-conducteur selon la revendication 1, caractérisé en ce que les électrodes (73) d'accumulation de condensateur sont partiellement disposées sur un second isolant intercouche (50) de façon à être situées au-dessus d'une partie des lignes de binaire (61) et des électrodes de grille (46, 47).
